# DEMANDE DE BREVET EUROPEEN

(11) **EP 0 999 593 A1**
(43) Date de publication de la demande: **10.05.2000**
(21) Numéro de dépôt: 99402682.1
(22) Date de dépôt: 28.10.1999
(51) Int. Cl.: H01L 25/065, H01L 25/10

(54) **Structure d'interconnexion tridemensionnelle de plusieurs circuits pour former un boitier multicomposants.**

(30) Priorité: 06.11.1998 FR 9813986
(71) Demandeur: BULL S.A., 78430 Louveciennes (FR)
(72) Inventeur: Courant, Patrick, 78220 Viroflay (FR); Dehaine, Gérard, 92320 Chatillon (FR); Stricot, Yves, 78450 Villepreux (FR)

(57) **Abrégé**

Structure d'interconnexion de plusieurs circuits intégrés (11) et supports (12), disposant de bornes d'entrée ou de sortie, et montés sur des supports superposés selon plusieurs étages (S6, S7), pour former un boîtier multicomposants en reliant entre elles chaque zone conductrice (18 à 19) à l'extrémité de chaque conducteur (14.7, 14.6) de chaque support supérieur à une zone conductrice à l'extrémité des conducteurs de chaque support inférieur par boule de soudure (15) selon la technologie BGA caractérisée en ce que, sur chaque support, les conducteurs sont disposés de façon à permettre d'interrompre sélectivement la continuité électrique entre certaines des bornes extérieures du boîtier multicomposants et une ou plusieurs des bornes d'entrée-sortie du circuit intégré monté.

## Description

L'invention se rapporte à une structure d'interconnexion tridimensionnelle de plusieurs circuits intégrés pour former un boîtier multicomposants. L'invention s'applique, notamment, à la technologie de connexion par boules en réseau appelée communément "Technologie BGA" (Ball Grid Array) et plus particulièrement, celle dite "à ruban" ou "TBGA" (Tape BGA) ou même flex BGA.

La connexion bidimensionnelle classique consiste à interconnecter des circuits intégrés sur une surface, une face d'une carte de circuits imprimés par exemple. La connexion tridimensionnelle consiste à utiliser le volume situé au-dessus de la surface de connexion classique pour interconnecter plusieurs circuits intégrés. La structure de connexion tridimensionnelle qui en résulte est appelée "boîtier multicomposants", connu sous la terminologie anglo-saxonne "multichip package" ou "3-D package". On connaît de nombreux types de tels boîtiers.

Ainsi, le brevet américain 5,594,275 enseigne un tel boîtier multicomposants représentant des bornes extérieures et formé de la superposition selon plusieurs étages d'ensembles circuit intégré-support, les circuits intégrés disposant de bornes d'entrée ou de sortie et étant montés sur ces supports, les supports comportant des pistes conductrices disposées du côté du circuit intégré et communiquant avec une autre partie conductrice disposée en-dessous du support pour assurer la continuité électrique avec le support inférieur par l'intermédiaire de boules conductrices. Les pistes conductrices situées au-dessus du support sont reliées aux bornes d'entrée-sortie des circuits intégrés par des fils conducteurs soudés point par point. Cette technologie présente l'inconvénient d'avoir à connaître la topographie d'implantation des bornes du semi-conducteur ainsi que la topographie des conducteurs des supports et d'avoir à programmer, en fonction de la machine, chaque circuit pour réaliser les liaisons point par point. Selon les étages, la programmation devra être modifiée pour tenir compte des problèmes d'adressage ou de sélection du circuit intégré.

Ainsi, on conçoit que les modifications de produits peuvent poser des problèmes de programmation peu compatible avec une production à grande échelle selon un processus peu coûteux. La connexion par des fils soudés point par point d'un boîtier multicomposants est également une technologie complexe à mettre en oeuvre. Ceci présente donc des inconvénients majeurs.

Notamment, un boîtier multicomposants 3D doit pouvoir incorporer un grand nombre de composants au moyen d'un procédé simple, efficace et peu coûteux. Actuellement, la réunion de tous ces critères est difficilement compatible.

Un premier but de l'invention est une solution à ce problème.

Ce premier but est atteint par le fait que la structure d'interconnexion tridimensionnelle de plusieurs circuits intégrés et supports disposant de bornes d'entrée ou de bornes de sortie et montés sur des supports superposés selon plusieurs étages pour former un boîtier multicomposants en reliant entre elles chaque zone conductrice à l'extrémité de chaque conducteur de chaque support supérieur à une zone conductrice à l'extrémité des conducteurs de chaque support inférieur par boule de soudure selon la technologie BGA est caractérisée en ce que, sur chaque support, les conducteurs sont disposés de façon à permettre d'interrompre sélectivement la continuité électrique entre certaines des bornes extérieures du boîtier multicomposants et une ou plusieurs des bornes d'entrée-sortie du circuit intégré monté sur le support, tout en maintenant le même nombre de points de soudure entre les bornes d'entrée-sortie du circuit intégré et les extrémités des conducteurs reliées à ces bornes.

Selon une autre particularité, les supports comportent plusieurs pistes ou plans conducteurs connectés d'une part, à un nombre égal de bornes extérieures du boîtier multicomposants et d'autre part, par une liaison conductrice apte à être interrompue, à une seule extrémité du conducteur lui-même relié à une seule borne d'entrée-sortie du circuit intégré, la borne extérieure de sélection du boîtier multicomposants changeant selon l'étage du circuit intégré.

Selon une autre particularité, les points de soudure entre les circuits intégrés et les extrémités des conducteurs sont réalisés par des boules conductrices selon la technologie BGA.

Selon une autre particularité, les boules ont un diamètre équivalent à l'épaisseur du circuit intégré monté sur chaque support.

Selon une autre particularité, les circuits intégrés sont de types différents (circuit d'entrée-sortie, mémoire, CPU, unité centrale de traitement).

Selon une autre particularité, les bornes d'entrée-sortie du circuit intégré sont constituées de pattes directement soudées sur les extrémités des conducteurs.

Selon une autre particularité, les supports sont réalisés en ruban selon la technologie TAB.

Selon une autre particularité, le circuit intégré supérieur est monté en contact thermique avec un dispositif de refroidissement.

D'autres particularités et avantages de la présente invention apparaîtront plus clairement à la lecture de la description ci-après faite en référence aux dessins annexés dans lesquels :
- la figure 1 représente une vue schématique en coupe transversale d'un boîtier conforme à l'invention, incluant huit supports pour huit circuits intégrés ;
- la figure 2 représente une vue en coupe transversale partielle de deux supports pour les circuits intégrés supérieurs du boîtier représenté sur la figure 1 ;
- la figure 3 représente une vue de dessus d'un support du boîtier, illustrant un motif de la couche conductrice du support ;
- la figure 4 représente une vue de dessus d'un circuit intégré monté sur le support représenté sur la figure 3 ;
- la figure 5 représente une vue schématique en coupe partielle similaire à celle de la figure 1, illustrant une deuxième variante de réalisation d'un boîtier conforme à l'invention.

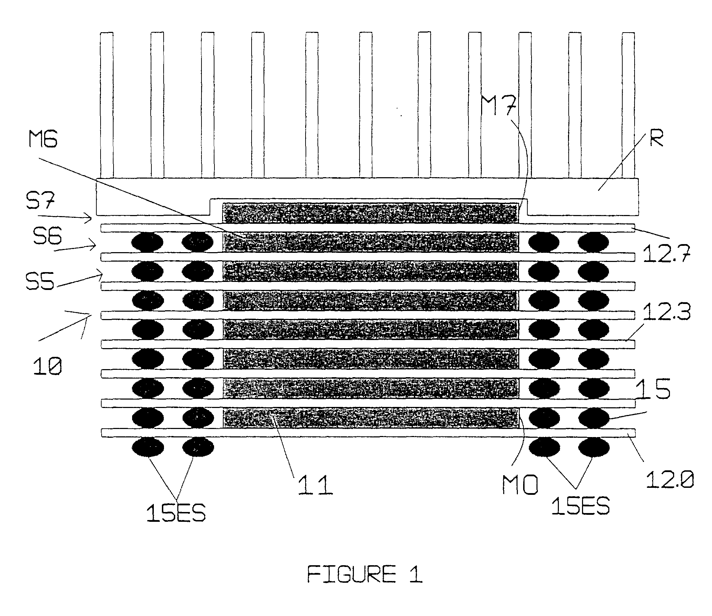

La figure 1 illustre un boîtier multicomposants (10) pour l'encapsulation tridimensionnelle de circuits intégrés (11). Dans l'exemple qui suit, le boîtier (10) contient huit circuits intégrés constituant des mémoires M0-M7 de 8 Mbits chacune. Chaque mémoire est un rectangle d'environ 20 mm de long et 10 mm de large. Les huit mémoires M0-M7 empilées par étages dans le boîtier (10), sont identiques et montées chacune sur un support (12) respectivement (12.0 à 12.7). Les supports (12) illustrés sont identiques et constituent chacun un ruban monocomposant de type TBGA (Tape Ball Grid Array), tel que décrit, par exemple, dans le document EP-A-0 717 442 du demandeur. Chaque support a environ 23 mm de long et 14 mm de large. Le boîtier (10) illustré est pourvu d'un dispositif de refroidissement (R), tel qu'un radiateur à ailettes dans l'exemple illustré. La hauteur du boîtier sans le radiateur est d'environ 5 mm et d'environ 11 mm avec son radiateur.

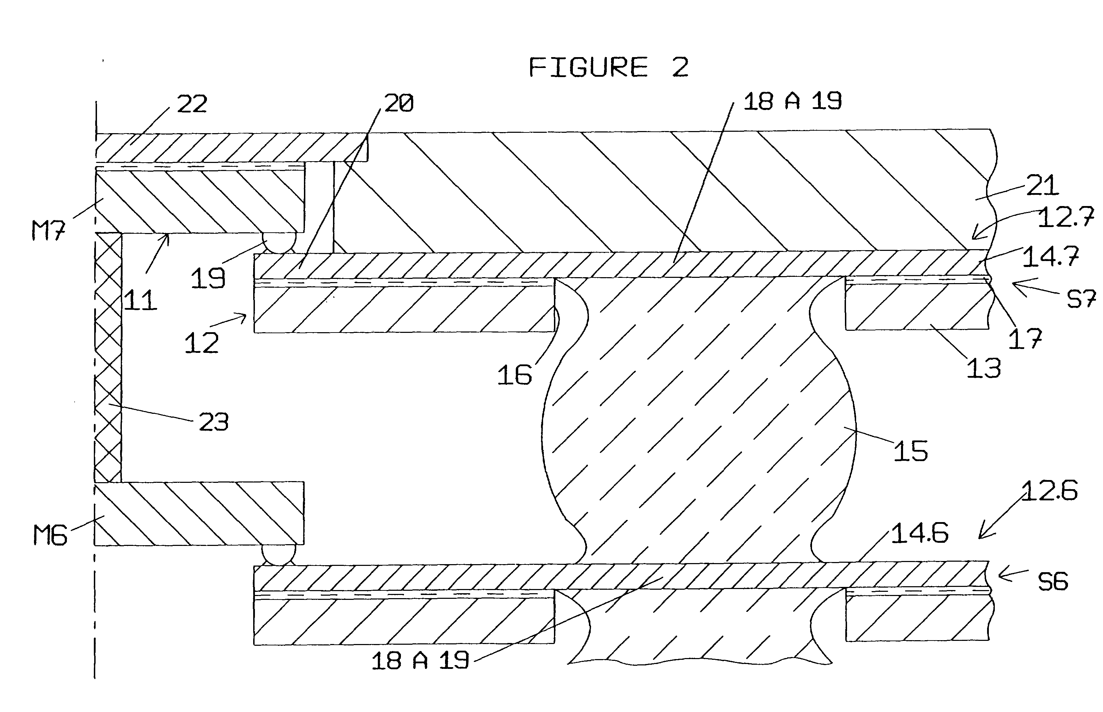

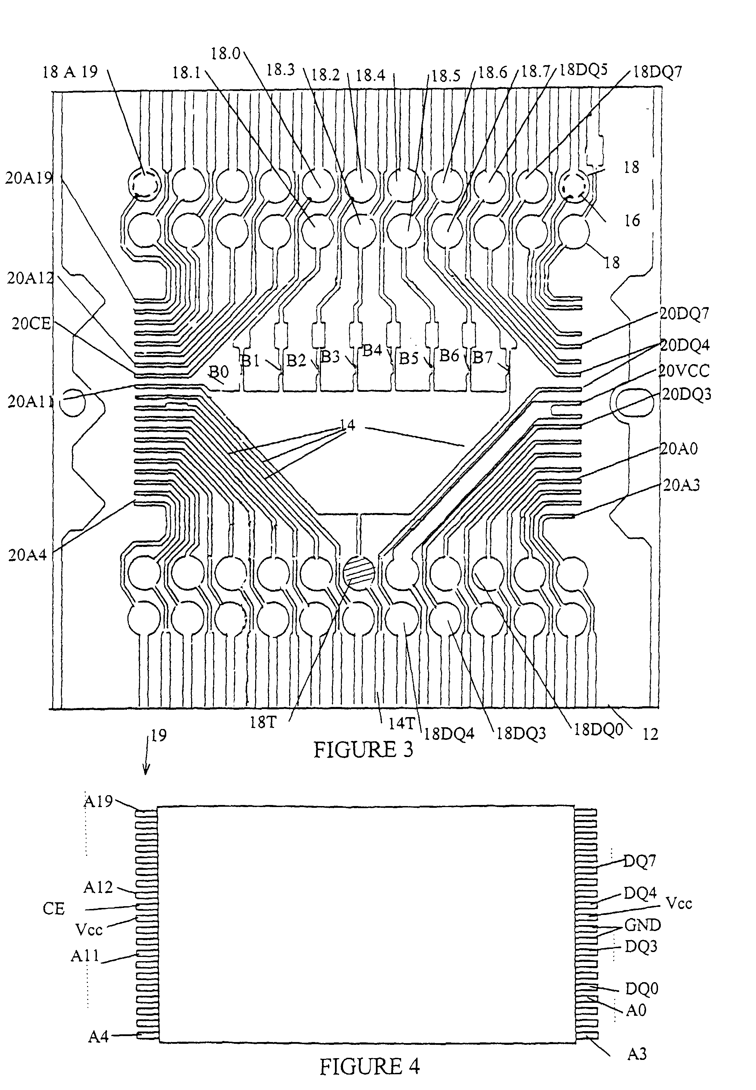

La figure 2 illustre un détail agrandi et partiel des deux supports supérieurs (12.7 et 12.6) du boîtier (10). Les dimensions des éléments constitutifs du support ont été volontairement modifiées afin de bien les mettre en relief. Chaque support (12) est du type ruban TAB classique et comprend un film isolant (13), en polyimide ou polyester par exemple, dont une face porte un ensemble de conducteurs (14), par exemple, en cuivre et l'autre face est munie de traversées (16) ménagées dans le film (13), dont le fond, formé par la face inférieure des conducteurs respectifs (14), est utilisé comme plage de connexion (18). Elle est reliée à une autre plage de connexion (18) conductrice formée sur le côté du conducteur (14.6) orienté vers l'extérieur du ruban inférieur (12.6) par une ou plusieurs boules conductrices (15). Dans l'exemple illustré, le support (12) est du type à trois couches, à savoir une couche constituant le film (13) de polyimide ou polyester ayant ordinairement une épaisseur comprise entre 50 et 125 µm, une couche conductrice composée des conducteurs (14) ayant une épaisseur couramment de l'ordre de 20 à 35 µm et une couche adhésive (17) de l'ordre de 25 µm d'épaisseur. Cependant, le support (12) peut être du type classique à deux couches, évitant l'emploi de la couche adhésive (17) et permettant l'emploi d'un film (13) plus mince, typiquement de l'ordre de 50 µm. Le ruban conducteur (14) peut également posséder deux couches en métal. Une première couche est dédiée à un plan d'alimentation, telle que définie en liaison avec la figure 3 et une deuxième couche sert à abaisser l'inductance des lignes et à réaliser un écran de blindage électromagnétique. Le diamètre des boules est lié à l'épaisseur du circuit intégré et au pas entre ces boules. Le diamètre peut varier de 300 µm pour un pas et de 500 µm à 700 µm pour un pas de 1,27 mm. Les boules conductrices (15) réalisent la continuité électrique entre le conducteur (14.7) d'un premier support (12.7) et le conducteur (14.6) d'un second support (12.6). Les conducteurs au niveau des plages (18) de connexion et des boules (15) ont une section adaptée au diamètre des boules (15) réalisées en alliage, étain et plomb refondu de façon à éviter l'écoulement du métal liquide le long du conducteur pendant la refusion. Dans le cas d'un ruban bi-couche métal, les boules conductrices (15) réalisent la continuité électrique entre un conducteur (14.7) correspondant, par exemple, à une alimentation du circuit intégré, la deuxième couche métal du ruban et le conducteur (14.6) lui-même utilisé en tant que borne d'alimentation. Ce type de connectique est amplement décrit dans le brevet EP 0 717 442 A1 de la demanderesse .

La figure 3 illustre une vue de dessus de la face du film (13) portant les conducteurs (14). En référence aux figures 2 et 3, l'axe central du circuit intégré (11), aligné avec les extrémités CE et V_{CC} ,est aussi aligné avec les extrémités des pistes conductrices CE et Vcc. Les côtés du circuit intégré sont parallèles aux côtés respectifs du support (12). Les conducteurs-(14) sont des pistes fines, dont les extrémités de connexion vers l'extérieur du support sont élargies pour former des plages (18) de connexion constituant le fond des traversées (16) ménagées dans le film (13). Les extrémités dites "intérieures" (20) de connexion, vers le circuit intégré et formées par le conducteur (14), sont placées en correspondance avec les plots respectifs (19) du circuit intégré (11) formant, par exemple, la mémoire MO du premier étage. Les plots (19) illustrés à la figure 4 sont des pattes disposées suivant les deux petits côtés de la mémoire formant la largeur et s'étendant à l'extérieur de ces côtés et dans un même plan. Les plages de connexion (18) sont alignées suivant deux rangées parallèles et extérieures à la grande dimension de la mémoire. La figure 3 fait aussi ressortir que le support (12) d'une mémoire M est avantageusement constitué par découpage d'une bande TAB.

La figure 4 illustre une vue de dessus d'une mémoire (11) dont les entrées-sorties sont constituées soit de plots (19, fig. 2), soit de pattes (19, fig. 4). Les plots (19) d'entrée-sortie ont des fonctions respectives prédéterminées. Celles illustrées ne sont données qu'à titre indicatif dans le but de ne mentionner que celles qui servent dans le cadre de l'invention. Les deux côtés opposés de la mémoire (11) suivant la petite dimension ont chacun vingt plots. La mémoire utilisée est par exemple une mémoire non volatile FEEPROM (Flash Electrically Erasable and Programmable Read Only Memory) du type F28F008SA fabriquée par la société Intel. L'un des deux côtés comporte notamment huit plots (19), ou pattes d'entrée-sortie, représentatifs des bits de données d'entrée-sortie DQ0-DQ7, deux pattes ou plots adjacents représentatifs de la masse électrique GND, un plot ou patte de tension d'alimentation V_{CC} et quatre plots ou pattes d'entrée d'adressage A0-A3. Le côté opposé comporte seize autres plots ou pattes d'entrée d'adressage A4-A19 de la mémoire, un plot ou patte de sélection de mémoire ou circuit CE (Chip Enable) et un plot ou patte de tension V_{CC}. Le plot de sélection CE et le plot de tension sont placés entre les plots A4-A11 et A12-A19. Les plots (19) sont posés sur les extrémités (20) des pistes (14) du support (12) et y sont fixés par soudure, par exemple.

La figure 3 montre que le conducteur (14) destiné à être relié au plot de sélection CE de la mémoire est pourvu de moyens de sélection constitués ici de huit branches B0-B7 pour un boîtier à huit étages se terminant par huit plages respectives de connexion (18.0 à 18.7) de sélection. Ainsi, le nombre de plages de connexion (18) du ruban TAB ou support de circuit intégré (12) est égal au nombre de plots d'entrée-sortie (19) du circuit intégré (11) augmenté de la valeur correspondant au nombre d'étages de circuit empilés en l'occurrence 8 pour l'exemple. Chaque extrémité dite "intérieure" (20) de chaque conducteur (14) relie la borne de commande du circuit intégré (11) à une plage de connexion (18) associée. De cette façon, la ligne A19 du bus d'adresse du circuit intégré (11) est reliée à l'extrémité 20A19 du conducteur dont l'autre extrémité sur le support (12) est constituée par la plage de connexion 18A19. Chaque plage de connexion (par exemple 18A19) d'un étage de circuit (par exemple S7) est reliée à la plage correspondante située en vis-à-vis de l'étage inférieur du circuit (par exemple S6). L'assemblage des mémoires (11) pour former le boîtier (10) sur chaque support (12) permet de sélectionner la mémoire selon le niveau qu'elle occupe dans le boîtier. Par exemple, en supposant que les numéros croissent avec les niveaux, la première mémoire (11), au bas du boîtier, porte le numéro 0. La branche B0 est donc sélectionnée, par exemple, en coupant les autres branches B1-B7 dans leur zone d'affaiblissement respectives. Les entrées (18.1 à 18.7) de l'entrée CE du circuit (11) de l'étage 0 sont ainsi isolées et seule l'entrée (18.0) permet la sélection de la mémoire M0. Les mémoires M0-M7 sont donc empilées en sélectionnant les branches B0-B7 correspondant à la plage de connexion (18.0 à 18.7) choisie pour activer le circuit intégré.

La figure 1 représente également les bornes d'entrée-sortie (15 ES) du boîtier (10) qui sont aussi des boules conductrices (15) pour la connexion à un support de connexion, tel que, par exemple, une carte de circuits imprimés non représentée. Le support (12.0) inférieur a également huit bornes de sélection (18.0 à 18.7) de circuit CE connectées d'une part, chacune à un circuit (11) respectif d'un étage du boîtier et d'autre part, au circuit imprimé pour l'interconnexion de plusieurs circuits intégrés. Les boules sont disposées coplanairement selon un montage dit "de surface" et appelé communément "CMS" (composants montés en surface) ou "SMT" (Surface Mount Technology).

Un procédé de formation du boîtier (10) à n étages ressort clairement des figures 1 et 2. Celui-ci consiste à fabriquer d'abord des ensembles support (12) de circuit intégré (11) sur lesquels on a préalablement sectionné les n-1 conducteurs de l'ensemble n de conducteurs de validation du circuit intégré de l'étage, en préservant à chaque fois un conducteur différent. A partir d'un premier ensemble support circuit, tel que celui représenté sur la figure 3, on superpose un second support (12) tel que représenté sur la figure 2, et on fixe par brasage les deux ensembles support circuit. En répétant successivement cette opération pour les n étages, on obtient le boîtier (10). De préférence, les boules (15) du premier support sont des boules de brasure tendre ou refusionnable tandis que celles des autres supports sont des boules de brasure dure ou non refusionnable. Par exemple, une brasure tendre peut être faite d'étain et de plomb dans des proportions respectives d'environ 60% et 40% et une brasure dure, de 90% et 10%. Dans ces conditions, le soudage des boules d'entrée-sortie du boîtier à une carte de connexion peut se faire sans endommager les soudures des boules superposées des autres supports (12). Selon ce procédé, le soudage des supports est successif et fait au moyen d'un outil de soudage individuel ou collectif des boules. Selon un autre procédé possible, les supports (12), pourvus sur une face des boules conductrices (15) de soudure, peuvent être superposés et placés dans un four pour la fixation des supports entre eux.

Comme représenté à la figure 2, la mémoire supérieure M7 est en contact thermique avec une plaque de diffusion thermique (22) soutenue par un cadre isolant (21) entourant la mémoire M7 et portée par le support supérieur S7. La plaque (22) est destinée à recevoir un dispositif de refroidissement R, comme indiqué à la figure 1. Les mémoires peuvent être aussi en contact thermique entre elles par l'intermédiaire d'une couche de diffusion thermique (23). Dans ce cas, les conducteurs sont disposés en périphérie de la surface occupée par le diffuseur thermique (23) et le support (12) est découpé selon cette surface.

De nombreuses variantes peuvent encore être apportées au mode de réalisation décrit en référence aux figures 1 à 4. Dans l'exemple illustré, les boules (15) sont superposées et forment des colonnes parallèles et verticales de distribution des signaux et potentiels d'alimentation des mémoires. D'autre part, les boules pourraient aussi être remplacées par d'autres moyens, tels que des dés ou des pions conducteurs. Le conducteur (14, figure 3), qui est relié à l'extrémité intérieure de sélection (20 CE) et au nombre de plages de connexion de sélection, est également relié à une plage de connexion de test (18T) qui est la seule à ne pas être en vis-à-vis d'une traversée (16) et qui se trouve donc isolée des autres étages par l'isolement (13) représenté en hachuré sur la figure 3. Cette plage de connexion de test (18T) est reliée à une bande conductrice de test (14T) accessible en bordure de ruban et permettant la connexion électrique pour tester le composant monté sur le support avant assemblage avec les autres étages de composants.

Hormis l'exception ci-dessus, il ressort de la description qui précède que l'invention tire profit des traversées (16) faites directement dans les supports superposés (12) et des boules ou autres éléments de connexion (15) associés à ces traversées. Les chemins d'entrée-sortie dans le boîtier sont ainsi formés lors de la superposition des éléments (15) et des conducteurs (14) associés. Dans les exemples qui viennent d'être présentés, les traversées ne sont pas des trous métallisés nécessitant-que les conducteurs (14) relient chaque traversée à une borne.

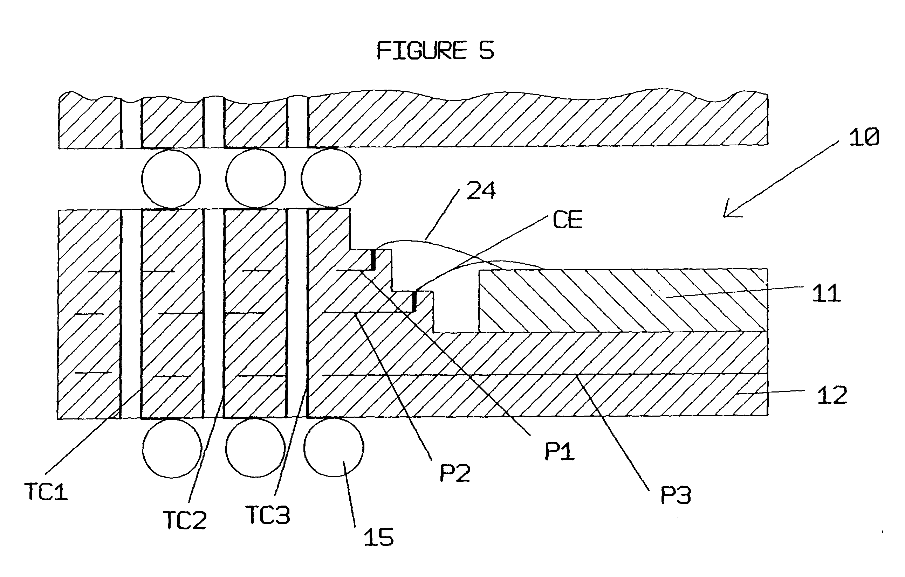

La figure 5 illustre une autre variante de réalisation possible et avantageuse d'un boîtier (10) multicomposants tridimensionnel conforme à l'invention utilisant la superposition de trous métallisés et d'éléments de connexion (15). Dans le boîtier (10) de la figure 5, les supports (12) sont des boîtiers monocomposants ou multicomposants bidimensionnels de type BGA, tels que décrits dans le brevet français 2 747 235. Dans un boîtier ordinaire, un cadre entourant le ou les circuits intégrés incorpore plusieurs plans conducteurs superposés, par exemple, P1, P2, P3. Les plans sont séparés entre eux par des couches isolantes et connectés entre eux par des traversées conductrices TC1, TC2, TC3. Les traversées sont ordinairement faites de trous métallisés percés à travers toute la hauteur du cadre du boîtier et sont en liaison avec des boules (15) selon la technologie BGA ou des broches selon la technologie PGA (Pin Grid Array). La liaison peut être directe ou indirecte, par l'intermédiaire de courts fils conducteurs (24) dans l'exemple illustré. La connexion du chip au substrat peut être faite également par un ruban TAB, en particulier, pour les applications hautes fréquences de 10 à 40 GHz. Le substrat n'a alors qu'un seul niveau de connectique P1. Les trous sont ordinairement bouchés, par exemple, par une résine. Selon la variante représentée sur la figure 5, le boîtier (10) est formé par empilage de plusieurs boîtiers BGA par l'intermédiaire de leurs boules. La liaison des boules aux trous correspondants fait que l'autre côté du cadre présente des plages de liaison avec les trous respectifs placés en correspondance avec les boules du boîtier BGA supérieur adjacent. Les boules et les trous métallisés superposés constituent ainsi un chemin d'entrée-sortie. Dans le cas où les circuits intégrés (11) sont des mémoires M, comme dans le boîtier (10) des figures 1 à 4, les chemins d'entrée-sortie sont similaires à ceux de ces figures et le boîtier (10) comporte aussi des moyens de sélection. Ce peut être aussi des mémoires M montées, comme indiqué à la figure 5. Dans ce cas, les supports (12) portent des trous métallisés servant uniquement d'interconnexion entre supports adjacents et n'étant pas utilisés dans le support même. En d'autres termes, les supports se distinguent alors des boîtiers BGA ordinaires où tous les trous métallisés ont des fonctions spécifiques au support et sont pour cela en liaison avec des conducteurs du boîtier. Dans les supports (12) d'un tel boîtier (10), des trous métallisés peuvent n'avoir aucune fonction spécifique au support et n'être pas connectés à des conducteurs du support. Les connexions de chaque signal CE de validation du circuit intégré passent, comme dans la variante des figures 1 à 4, à travers un trou métallisé différent pour chaque circuit intégré et à chaque étage, un seul trou métallisé est relié au plan du conducteur P2 qui véhicule le signal CE à l'entrée correspondante du circuit intégré.

Bien sûr, les boules pourraient être remplacées par des broches introduites dans les traversées correspondantes du support et du support inférieur. En variante, des supports (12) pourraient être pourvus de broches des deux côtés et servir de supports mâles, tandis que d'autres pourraient ne porter que des trous métallisés et servir de supports femelles. On comprend aussi que ce type de boîtier (10) pourrait incorporer tout autre type de circuits intégrés. Par exemple, le boîtier (10) peut être fait de huit circuits intégrés (11), dont quatre sont des processeurs et quatre sont les antémémoires correspondantes. Les supports (12) seraient adaptés aux connexions nécessaires à chaque type de circuit, un type de support serait adapté aux processeurs et l'autre type de support serait adapté à la connexion des antémémoires. Le boîtier (10) aurait donc comme avantages majeurs, d'être très compact, d'éviter l'emploi d'un bus, d'offrir des connexions très courtes, propices aux très hautes fréquences, d'utiliser des supports BGA ou PGA classiques et d'avoir un coût relativement faible par rapport au montage classique. De même, le boîtier peut comporter un assemblage d'un nombre quelconque d'étages comportant des circuits différents, tels que circuit d'entrée-sortie, mémoire cache, CPU ou autres.

D'autres modifications à la portée de l'homme de métier font également partie de l'esprit de l'invention.

## Revendications

1. Structure d'interconnexion de plusieurs circuits intégrés (11) et supports (12), disposant de bornes d'entrée ou de sortie, et montés sur des supports superposés selon plusieurs étages (S6, S7), pour former un boîtier multicomposants en reliant entre elles chaque zone conductrice (18 à 19) à l'extrémité de chaque conducteur (14.7, 14.6) de chaque support supérieur à une zone conductrice à l'extrémité des conducteurs de chaque support inférieur par boule de soudure (15) selon la technologie BGA, caractérisée en ce que, sur chaque support, les conducteurs sont disposés de façon à permettre d'interrompre sélectivement la continuité électrique entre certaines des bornes extérieures du boîtier multicomposants et une ou plusieurs des bornes d'entrée-sortie du circuit intégré monté sur le support tout en maintenant le même nombre de boules conductrices, selon la technologie BGA, entre les bornes d'entrée-sortie du circuit intégré et les extrémités des conducteurs reliées à ces bornes.

2. Structure d'interconnexion de plusieurs circuits intégrés (11) et supports (12) selon la revendication 1, caractérisée en que les supports comportent plusieurs pistes (18.0-18.7) ou plans conducteurs connectés d'une part, à un nombre égal de bornes extérieures (15 ES) du boîtier multicomposants et d'autre part, par une liaison conductrice (B0 à B7) apte à être interrompue, à une seule extrémité (20 CE) du conducteur lui-même relié à une seule borne d'entrée-sortie (19 CE) du circuit intégré, la borne extérieure (15 ES) de sélection du boîtier multicomposants (10) changeant selon l'étage (S0 à S7) respectif du circuit intégré.

3. Structure d'interconnexion de plusieurs circuits intégrés (11) et supports (12) selon la revendication 2, caractérisée en ce que les boules (15) ont un diamètre équivalent à l'épaisseur du circuit intégré monté sur chaque support.

4. Structure d'interconnexion de plusieurs circuits intégrés (11) et supports (12) selon une des revendications précédentes, caractérisée en ce que les circuits intégrés sont de types différents (circuit d'entrée-sortie, mémoire, CPU, unité centrale de traitement).

5. Structure d'interconnexion de plusieurs circuits intégrés selon la revendication 1 ou 2, caractérisée en ce que les bornes d'entrée-sortie du circuit intégré sont constituées de pattes directement soudées sur les extrémités des conducteurs.

6. Structure d'interconnexion de plusieurs circuits intégrés (11) et supports (12) selon une des revendications 1 à 5, caractérisée en ce que les supports (12) sont réalisés en ruban selon la technologie TAB.

7. Structure d'interconnexion de plusieurs circuits intégrés (11) et supports (12) selon une des revendications précédentes, caractérisée en ce que le circuit intégré supérieur est monté en contact thermique avec un dispositif de refroidissement.
